(19) Europäisches Patentamt
European Patent Office
Office européen des brevets

(11) Publication number: 0 162 570 B1

(12) **EUROPEAN PATENT SPECIFICATION**

(45) Date of publication of patent specification: 25.07.90

(51) Int. Cl.$^5$: **C 08 F 236/04**, G 03 F 7/027

(21) Application number: 85302637.5

(22) Date of filing: 15.04.85

(54) **A conjugated diene copolymer, a process for producing the copolymer, and a photosensitive composition comprising the copolymer.**

(30) Priority: 13.04.84 JP 74546/84
17.10.84 JP 216367/84

(43) Date of publication of application:
27.11.85 Bulletin 85/48

(45) Publication of the grant of the patent:
25.07.90 Bulletin 90/30

(84) Designated Contracting States:
DE FR GB IT

(56) References cited:
DE-A-2 653 822
DE-A-2 822 961
FR-A-2 350 625

(73) Proprietor: JAPAN SYNTHETIC RUBBER CO., LTD.
11-24, Tsukiji-2-chome Chuo-ku
Tokyo 104 (JP)

(72) Inventor: Enyo, Hiroji
1377-51, Yasuzukacho
Suzuka-shi (JP)
Inventor: Iwanaga, Shin-ichiro
1, Morikayamacho
Yokkaichi-shi (JP)
Inventor: Takemura, Yasuhiko
18-16, Mitakidai-4-chome
Yokkaichi-shi (JP)

(74) Representative: Tubby, David George et al
MARKS & CLERK 57-60 Lincoln's Inn Fields
London WC2A 3LS (GB)

**The file contains technical information submitted after the application was filed and not included in this specification**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 162 570 B1

Courier Press, Leamington Spa, England.

**Description**

This invention relates to a photosensitive composition comprising a conjugated diene copolymer.

Synthetic resins have hitherto been used as vehicles for coatings and inks or as adhesives. However, when the coating surface and the adhering surface are flexible, ordinary synthetic resins are unsuitable for applying to the surface, and it is necessary to use a resin having a rubber elasticity, namely a rubber. Ordinary acrylic rubbers and diene rubbers are applied in the form of a solution in an organic solvent because they are inherently insoluble in water and are also insoluble in aqueous alkali or acid solutions.

Many organic solvents are harmful to the human body and are inflammable. Therefore, if the organic solvents could be replaced by an aqueous solvent, it would be very advantageous from a safety viewpoint.

Among the resins soluble in aqueous solvents are known carboxyl group-containing polymers. However, these polymers have inferior rubber elasticity as well as the transparency required for paints, for vehicles of inks and for adhesives.

Example 66 of the French Specification 2350625 discloses a composition consisting of 100 grams of a polymer (the composition of which is butadiene/methymethacrylate/acrylic acid in molar proportions 55/30/15 and of number average molecular wieght 32,000) and photosensitive monomers (6.4 grams of ethoxydiethylene glycol acrylate and 57.1 grams of ethylene glycol dimethacrylate).

The polymer produced from the above is a linear polymer to which no polyfunctional monomer is copolymerised. In contrast to this, the polymer components of the present invention have copolymerised therewith a *polyfunctional* alkenyl monomer such as ethylene glycol dimethacrylate or the like, and the polymer is accordingly partially crossed-linked. The effect of copolymerisation in this way is to enhance the processability of the resulting photosensitive composition and the smoothness of the product. Moreover, the developing time is greatly shortened, which is an unpredictable and unexpected consequence.

The nonaethylene glycol dimethacrylate used as a photosensitive monomer in Example 66 of the French Patent Specification is itself a polyfunctional alkenyl monomer. However, in that Example, the monomer is not used in a form where it can copolymerise with the other constituents and thereby form a partially cross-linked polymer. It is used as a photosensitive monomer and is blended with the polymer. In the present invention the purpose is to form a three-dimensional or reticulate structure and to impart a mechanical strength advantage. Only when the polymer has a particular internal structure as achieved by polymerising the polyfunctional alkenyl monomer does the processability, smoothness, and developing time show the improvement. The difference in properties has achieved between copolymerisation and blending cannot be predicted from the French Specification.

Conjugated diene copolymers soluble in aqueous alkali solutions have been proposed in Japanese Patent Publication No. 1,140/83 as components of photosensitive compositions for use in photoresists. Such copolymers, however, have insufficient transparency and further require improved rubber elasticity. Furthermore, the photosetting property of the copolymer is also insufficient.

Recently, there has been proposed a photosensitive resin composition comprising: (I) a copolymer comprising units derived from (A) a conjugated diolefin (diene) hydrocarbon, (B) an α,β-ethylenically unsaturated carboxylic acid, and optionally (C) a monoolefinically unsaturated compound; (II) a photopolymerizable unsaturated monomer; and (III) a photosensitizer (Japanese Patent Publication No. 29,849,84). However, although this photosensitive resin composition has various advantages, its transparency and processability are unsatisfactory.

We have now discovered such a composition comprising a conjugated diene copolymer which is soluble in aqueous alkali solutions, excells in processability and photosetting property, retains excellent rubber elasticity and transparency even after photosetting and has excellent water resistance.

According to this invention there is provided a conjugated diene copolymer comprising: (A) from 10 to 60 mole % of units derived from a conjugated diene compound: (B) from 5 to 50 mole % of units derived from an α,β-ethylenically unsaturated carboxylic acid; (C) from 0.1 to 20 mole % of units derived from a polyfunctional alkenyl compound whose carbon-carbon double bonds are non-conjugated; (D) from 0 to 10 mole % of units derived from a diene compound having at least one carbon-carbon double bond in a carbocyclic system; and (E) from 0 to 80 mole % of units derived from a monoolefinically unsaturated compound, the sum of the amounts of (A), (B), (C), (D) and (E) being 100 mole %, said copolymer having an intrinsic viscosity of from 0.01 to 3.0 dl/g as measured at 30°C in dimethylformamide, (II) a photopolymerisable unsaturated monomer and (III) a photosensitizer.

Examples of conjugated diene compounds which form the monomer units (A) of the copolymer of this invention include 1,3-butadiene, isoprene, chloroprene and 1,3-pentadiene.

When the content of units (A) in the copolymer is less than 10 mole %, the copolymer has poor rubber elasticity. When the content of units (A) exceeds 60 mole %, the photosensitive composition of this invention does not readily retain a solid form and has poor processability. The content of units (A) in the copolymer is preferably from 15 to 40 mole %, more preferably from 20 to 40 mole %.

Examples of α,β-ethylenically unsaturated carboxylic acids, which form the monomer units (B) of the copolymer include acrylic acid, methacrylic acid, maleic acid, fumaric acid, monoethyl maleate and itaconic acid. When the content of units (B) is less than 5 mole %, the copolymer has poor solubility in aqueous alkali solutions. When the content of units (B) exceeds 50 mole %, the copolymer has poor rubber elasticity. The content of units (B) is preferably from 5 to 30 mole %, more preferably from 10 to 20 mole %.

The polyfunctional alkenyl compounds, which form the monomer units (C) of the copolymer have at least two non-conjugated vinyl linkages in the molecule, the reactivities of which are equivalent, and examples include: polyacrylates and polymethacrylates such as ethylene glycol dimethacrylate, ethylene glycol diacrylate, trimethylolpropane trimethacrylate, propylene glycol dimethacrylate, propylene glycol diacrylate and the like; divinylbenzene; and trivinylbenzene. When the content of units (C) is less than 0.1 mole %, the copolymer has poor transparency and processability. When the content of units (C) exceeds 20 mole %, the copolymer has poor solubility in aqueous alkali solutions. The content of units (C) is preferably from 0.1 to 10 mole %, more preferably from 0.1 to 5 mole %.

Examples of diene compounds having at least one of its carbon-carbon double bonds present in a carbocyclic system, which forms the monomer units (D) of the copolymer include dicyclopentenyl acrylate

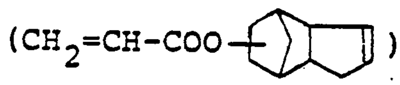

dicyclopentenyl methacrylate, dicyclopentenyloxyethyl acrylate

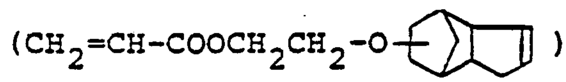

dicyclopentadiene, ethylidenenorbornene and vinylnorbornene. The units (D) are preferably derived from dicyclopentenyl acrylate or dicyclopentenyloxyethyl acrylate. When the content of units (D) exceeds 10 mole % the copolymer has poor solubility in aqueous alkali solutions. The content of units (D) is preferably from 0.5 to 10 mole %, more preferably from 1 to 5 mole %.

Examples of monoolefinically unsaturated compounds, which form the monomer units (E) of the copolymer include: acrylates, and methacrylates such as ethyl acrylate and methacrylate, butyl acrylate and methacrylate, α-ethylhexyl acrylate and methacrylate, octyl acrylate and methacrylate, dodecyl acrylate and methacrylate, methoxyethyl acrylate and methacrylate, ethoxyethyl acrylate and methacrylate, butoxyethyl acrylate and methacrylate, cyanoethyl acrylate and methacrylate, hydroxyethyl acrylate and methacrylate and hydroxypropyl acrylate and methacrylate; styrene; acrylonitrile; and vinyl chloride. These compounds can be used alone or in admixture depending upon the intended use of the product.

In order for the copolymer to retain the effect of the other components, the content of units (E) is at most 80 mole %, preferably from 20 to 80 mole %, more preferably from 20 to 60 mole %, and still more preferably from 30 to 50 mole %. When the content of units (E) is less than 20 mole %, the contents of the units (A) and the units (B) become relatively large. The ability of the copolymer to retain a solid form becomes bad when the contents of both units (A) and units (B) are too high, and the rubber elasticity of the copolymer becomes inferior when the content of units (B) is too high. The content of units (E) is most preferably from 30 to 40 mole %.

The copolymer has an intrinsic viscosity [η] of from 0.01 to 3.0 dl/g, preferably from 0.1 to 2.0 dl/g, as measured at 30°C in dimethylformamide. When the viscosity is less than 0.01 dl/g, it is difficult for the copolymer to keep a solid form, and hence handling of the copolymer is difficult. When the viscosity exceeds 3.0 dl/g, the copolymer has poor processability.

Such a copolymer can be produced by radical polymerising in an aqueous medium a mixture consisting of: (A) from 5 to 50% by weight of a conjugated diene compound; (B) from 5 to 30% by weight of an α,β-ethylenically unsaturated carboxylic acid; (C) from 0.5 to 20% by weight of a polyfunctional alkenyl compound having non-conjugated carbon-carbon double bonds; (D) from 0 to 20% by weight of a diene compound at least one of whose carbon-carbon double bonds is present in a carbocyclic system; and (E) from 0 to 60% by weight of a monoolefinically unsaturated compound, the sum of the amounts of (A), (B), (C), (D) and (E) being 100% by weight.

A molecular weight modifier is conveniently used for the control of the molecular weight of the copolymer. The amount of the molecular weight modifier used is normally from 0.1 to 5 g per 100 g of the monomers. Each monomer and polymerisation chemicals (such as a radical initiator and the like) may be added all at once before the start of the polymerization, or in desired portions after the start of the polymerization. The polymerization is ordinarily conducted in a reactor freed of oxygen at a temperature of from 0 to 50°C. Operational conditions such as temperature, stirring and the like can be changed as desired in the course of polymerization. The polymerization can be conducted continuously or batchwise.

Examples of radical polymerization initiators which can be used include: organic peroxides such as benzoyl peroxide, cumene hydroperoxide, *p*-methane hydroperoxide and lauroyl peroxide; diazo compounds such as azobisisobutyronitrile and the like; inorganic compounds such as potassium persulphate and the like; and redox catalysts such as an organic compound/iron sulphate mixture and the like. Examples of molecular weight modifiers which may be used include t-dodecyl mercaptan and dialkylxanthogen disulphides.

The copolymer can be used as the vehicle for a photosetting, water-based or oil-based paint or ink which can be applied even on flexible surfaces, or as a photosetting adhesive which is applicable even on

flexible surfaces. The copolymer can also be used as a toner material for copying and also as a material for photosensitive resins.

In the photosensitive composition of this invention, the residual double bonds resulting from the conjugated diene compound in the copolymer cause three-dimensional crosslinking by the action of actinic radiation, such as ultraviolet radiation or the like, which causes the composition to become insoluble in solvents. It has been found that, when the composition also contains a photopolymerizable unsaturated monomer having at least one ethylenically unsaturated group in its molecule, the above-mentioned crosslinking reaction is accelerated and this greatly improves the mechanical strength of a printing plate or the like produced from the composition.

Examples of photopolymerizable unsaturated monomers (II) which may be used in the photosensitive composition of this invention include: unsaturated aromatic compounds such as styrene, α-methylstyrene, *m*-methylstyrene, *p*-methylstyrene, *p*-methoxystyrene, diisopropenylbenzene and divinylbenzene; unsaturated nitrile compounds such as acrylonitrile and methacrylonitrile; alkyl acrylates and methacrylates such as methyl (meth)acrylate, ethyl (meth)acrylate, propyl (meth)acrylate, butyl (meth)acrylate, isobutyl (meth)acrylate, t-butyl (meth)acrylate, pentyl (meth)acrylate, hexyl (meth)acrylate, 2-ethylhexyl (meth)acrylate, octyl (meth)acrylate, decyl (meth)acrylate and lauryl (meth)acrylate; hydroxyalkyl acrylates and methacrylates such as 2-hydroxyethyl (meth)acrylate and 2-hydroxypropyl (meth)acrylate; acrylates and methacrylates of alkoxyalkylene glycols such as methoxyethylene glycol and methoxypropylene glycol; α,β-ethylenically unsaturated carboxylic acids and functional equivalents, e.g. anhydrides, thereof such as maleic acid, fumaric acid, fumaric anhydride, crotonic acid, itaconic acid, itaconic anhydride, citraconic acid and mesaconic acid; monoesters of unsaturated polycarboxylic acids such as monoethyl maleate, monoethyl fumarate and monoethyl itaconate; diesters of unsaturated polycarboxylic acids such as dimethyl maleate, diethyl maleate, dibutyl maleate, dioctyl maleate, diethyl fumarate, dibutyl fumarate, dioctyl fumarate, dimethyl itaconate, diethyl itaconate, dibutyl itaconate and dioctyl itaconate; acrylamides and methacrylamides, such as acrylamide, methacrylamide, *N,N'*-methylenebisacrylamide and *N,N*-hexamethylenebisacrylamide; ethylene glycol diacrylate and dimethacrylate; diacrylates and dimethacrylates of polyalkylene glycols (in which the number of alkylene glycol units is from 2 to 23); and diacrylates, triacrylates, tetraacrylates, dimethacrylates, trimethacrylates, tetramethacrylates, oligomethacrylates and oligoacrylates of polyalcohols such as glycerine, pentaerythritol, trimethylolalkanes and tetramethylolalkanes (alkanes: methane, ethane and propane).

The photopolymerizable monomer (II) is preferably used in an amount of from 5 to 200 parts by weight, more preferably from 10 to 100 parts by weight, per 100 parts by weight of the copolymer (I). Two or more photopolymerizable monomers (II) may be used, provided the total amount falls within the above range.

When the proportion of the photopolymerizable monomer (II) is less than 5 parts by weight, neither sufficient photosetting of the photosensitive resin layer nor sufficient improvement of the mechanical strength of a printing plate can be expected. When the proportion exceeds 200 parts by weight, the rubber elasticity of the copolymer (I) is strikingly impaired and a reduction of the solvent resistance of the copolymer (I) results.

The photosensitizer (III) used in the photosensitive composition of this invention may be any ordinary photoreaction initiator, such as an α-diketone compound (e.g. diacetyl or benzil), an acyloin (e.g. benzoin or pivaloin), an acyloin ether (e.g. benzoin methyl ether, benzoin ethyl ether or benzoin propyl ether) or a polynuclear quinone (e.g. anthraquinone or 1,4-naphthoquinone). The photosensitizer (III) is preferably added in an amount of from 0.1 to 10 parts by weight, more preferably from 1 to 5 parts by weight, per 100 parts by weight of the copolymer (I).

When the amount of the photosensitizer (III) added is less than 0.1 part by weight, it is often impossible to sufficiently cure the composition. When the amount exceeds 10 parts by weight, not all of the photosensitizer added takes part in the reaction, and hence the excess is wasted; and, in some cases, the photosensitizer (III) has poor compatibility with the copolymer (I) or the photopolymerizable monomer (II), resulting in a non-uniform dispersion.

Commerical products of the above-mentioned photopolymerizable unsaturated monomer (II) ordinarily contain a small amount of a thermal polymerization inhibitor such as *p*-methoxyphenol or the like. This inhibitor exerts no influence on the light exposure of the photosensitive composition and rather acts as a storage stabilizer for the photosensitive composition. Therefore, in the production of the photosensitive composition, the commercial photopolymerizable unsaturated monomers as such can be added without removing the thermal polymerization inhibitor contained therein.

If necessary, there may further be added to the photosensitive composition a storage stabilizer such as: a hydroxyaromatic compound, for example hydroquinone, *p*-methoxyphenol, *p*-t-butylcatechol, 2,6-dit-butyl-*p*-cresol or pyrogallol; a quinone, for example benzoquinone, *p*-toluquinone or *p*-xyloquinone; or an amine, for example phenol-α-naphthylamine. The amount is preferably from 0.01 to 2 parts by weight per 100 parts by weight of the copolymer (I).

The photosensitive compositions of this invention comprising (I) a copolymer, (II) a photopolymerizable unsaturated monomer, and (III) a photosensitizer can be produced by adding, to a solution containing the copolymer (I) as produced by polymerization, appropriate amounts of a photopolymerizable unsaturated monomer (II) and a photosensitizer (III), thoroughly stirring the resulting mixture to obtain a uniform solution, and thereafter removing the solvent while warming the solution

under reduced pressure; alternatively, it may be produced by first removing the solvent from the above-mentioned copolymer solution under reduced pressure to obtain a highly viscous material or a solid material, and then adding, to the resulting material, a photopolymerizable unsaturated monomer (II) and a photosensitizer (III) with warming and stirring. The photosensitive composition thus produced is a liquid or a rubbery solid. The composition can, therefore, be formed into a photosensitive composition layer of a desired thickness by using a spacer of an appropriate thickness, by coating on a substrate by means of a roll coater or the like, or by compression or extrusion moulding, after which the photosensitive composition layer can be exposed to light through a negative film and developed to produce a photosensitive resin relief printing plate. The photosensitive composition has high rubber elasticity and is best suited for use in a flexographic printing plate. The substrate for the photosensitive composition layer preferably has about the same rubber elasticity as the photosensitive composition. For example, suitable substrates may be natural rubber sheet, a styrene-butadiene rubber sheet, a butadiene rubber sheet, an acrylonitrile-butadiene rubber sheet, an isoprene rubber sheet, an ethylene-propylene rubber sheet, a crystalline 1,2-butadiene rubber sheet or a soft vinyl chloride resin sheet. When the use of a substrate having a lower rubber elasticity is permitted, there can also be used, for example, a polyester film, a polypropylene film, a polystyrene film, a nylon film, a polyvinylidene chloride film, a polyethylene film and the like. When the photosensitive composition of this invention is used in fields such as newspaper printing, ordinary commercial printing and the like, there can be used, as the substrate, grained plates of aluminium, iron, magnesium and the like.

One of the characteristics of this invention is the developability of the composition with a dilute aqueous alkali solution. In this case, the alkali may be a conventional one and examples include sodium hydroxide, potassium hydroxide, lithium hydroxide, ammonia and lithium carbonate. An aqueous solution containing the alkali at a relatively low concentration, such as from 0.1 to 1.0% by weight can be used as the developing solution. As a matter of course, the photosensitive composition of this invention can be developed with not only an aqueous alkali solution but also with an organic solvent such as an alcohol, a ketone, an aromatic hydrocarbon or the like.

The photosensitive composition of this invention requires only a short time for light exposure because of its high photosensitivity and can be developed in 1 to 2 minutes with a dilute aqueous alkali solution because of its very high solubility in the dilute aqueous alkali solution. The photoset and developed composition can be used for printing immediately after drying, and hence the photosensitive composition of this invention can substantially improve the conventional complicated process and the time for producing rubber relief plates for flexographic printing.

In flexographic printing a rubber relief plate made from the photosensitive composition of this invention, a solvent-type flexographic ink can be used, of course. Since the photosensistive composition of this invention has good water resistance in spite of its high solubility in aqueous alkali solutions, there can also be used an aqueous flexographic ink, which is convenient, as there is a gradual shift from the use of solvent-type flexographic inks to aqueous-type flexographic inks in order to prevent air pollution.

The photosensitive composition of this invention not only provides a resin relief plate for flexographic printing, but can also be widely utilized as a photosensitive material in various fields such as relief plates for newspaper printing and ordinary commerical printing, name plates, printed circuit boards, displays and photo-adhesives. Besides, the photosensitive composition can be used in photopolymerizable, water-based and oil-based paints which can be applied even to flexible surfaces, as vehicles for inks which can be applied even to flexible surfaces and as adhesives which can be applied even to flexible surfaces.

In the photosensitive composition of this invention, each component has the following function and role.

When the conjugated diene compound (A) to form part of the copolymer (I) is incorporated into the copolymer by copolymerization, unreacted double bonds are left in the main or side chain of the copolymer, and, therefore, to the double bonds are added the radicals of the photopolymerizable unsaturated monomer (II), whereby the composition, after the photo-reaction, forms firmly a three-dimensional reticular stucture and, in addition, the water resistance and solvent resistance are increased. Further, the conjugated diene compound (A) incorporated into the copolymer imparts to the photosensitive composition the flexibility, namely rubber elasticity, which a flexographic printing plate must have.

The α,β-ethylenically unsaturated carboxylic acid (B) of the copolymer (I) increases the affinity of the photosensitive composition toward dilute aqueous alkali solutions, specifically, it permits the composition to be developed with an aqueous alkali solution.

The polyfunctional alkenyl compound (C) of the copolymer (I) improves the transparency and processability of the photosensitive composition.

The monoolefinically unsaturated compound (E) of the copolymer (I) improves the mechanical properties of printing plates produced from the photosensitive composition, particularly their rubber elasticity, strength and elongation. The compound (E) further improves the properties of the printing surface of the printing plates such as the ink acceptability and ink transferability.

The photopolymerizable unsaturated monomer (II) forming part of the photosensitive composition acts on the residual double bonds derived from the compound (A) as mentioned above to accelerate the cross-linking reaction in the photosensitive composition and to improve greatly the mechanical strength of printing plates produced from the composition after the cross-linking reaction.

Lastly, the photosensitizer (III) serves to impart sufficient curing to the photosensitive composition layer.

The invention is explained below with reference to the following Examples, and Comparative Examples, and to the accompanying drawing which shows in infrared spectrum of the product of Example 1.

Examples 1 to 3 and Comparative Examples 1 to 10

Using the following monomers and polymerization chemicals, polymerization was conducted at 30°C in a 20 litre autoclave:

| | | | | |
|---|---|---|---|---|
| Ethyl acrylate | 53 | parts | by | weight |
| Methacrylic acid | 20 | " | " | " |
| Butadiene | 20 | " | " | " |
| Ethylene glycol dimethacrylate | 2 | " | " | " |
| Dicyclopentenyl acrylate | 5 | " | " | " |
| Water | 250 | " | " | " |
| Sodium dodecylbenzene-sulphonate | 5 | " | " | " |
| Potassium persulphate | 0.27 | " | " | " |
| t-Dodecyl mercaptan | 0.6 | " | " | " |
| Cyanoethylated di-ethanolamine | 0.15 | " | " | " |
| Potassium hydroxide | 0.1 | " | " | " |

When the polymerization conversion reached 90%, 0.2 part by weight per 100 parts by weight of the monomers was added to terminate the polymerization. Then, the polymerization system was heated and the residual monomers were removed by steam distillation.

Thereafter, the polymer was coagulated by the addition of an aqueous calcium chloride solution. The resulting crumbs were water-washed and then dried at 50°C under vacuum to obtain a polymer sample for evaluation. The composition of the polymer obtained was measured by pyrolysis gas chromatography. The content of methacrylic acid was measured by dissolving the polymer in dioxane and subjecting the resulting solution to alkali titration. As a result, it was found that the polymer had the following composition: Ethyl acrylate/methacrylic acid/butadiene/ethylene glycol dimethacrylate/dicyclopentenyl acrylate = 44/17/36.2/0.8/2 (mole %).

The Tg of the polymer was measured by DSC, and found to be −35°C. The intrinsic viscosity [η] of the polymer as measured at 30°C in dimethylformamide was 0.31 dl/g. The infrared absorption spectrum of the polymer when a NaCl plate was used is as shown in the accompanying drawing.

By changing the kinds and amounts of the monomers and using the same polymerization procedure, polymerization was repeated. The compositions and test results of the polymers obtained are shown in Table 1. The polymer composition is given in mole %.

As can be seen in Comparative Examples 1 and 2, too low a content of the conjugated diene compound (A) gives a copolymer of poor rubber elasticity.

As can be seen in Comparative Example 3, too low a content of the α,β-unsaturated carboxylic acid (B) gives a copolymer of poor solubility in aqueous alkali solutions.

As can be seen in Comparative Example 4, too high a content of the acid (B) gives a copolymer of poor rubber elasticity.

As can be seen in Comparative Example 5, too low a content of the polyfunctional alkenyl compound (C) gives a copolymer having poor transparency and processability.

As can be seen in Comparative Example 6, too high a content of the compound (C) gives a copolymer having poor solubility in aqueous alkali solutions and a poor rubber elasticity.

As can be seen in Comparative Example 7, too high a content of the diene compound (D) at least one of whose carbon-carbon double bonds is in a carbocyclic system gives a copolymer having poor solubility in aqueous alkali solutions.

As can be seen in Comparative Examples 8 and 9, a copolymer having too high to too low an intrinsic viscosity has poor handling and processability.

As can be seen in Comparative Example 10, too high a content of the conjugated diene compound (A) gives a copolymer of poor processability.

The solubilities in aqueous alkali solutions, rubber elasticities, transparencies, water resistances and processabilities of the copolymers produced were measured according to the following test methods:

(1) Solubility in aqueous alkali solution

About 1 g of polymer was weighed. To it were added 100 ml of a 1% (by weight) aqueous potassium hydroxide solution, and the mixture was stirred at room temperature for 24 hours. Then, the whole volume was filtered through a 200 mesh wire net. The residue on the net was dried at 80°C for 20 hours under vacuum. The insoluble matter content (%) of the polymer was expressed as 100 × b/a (%) where *a* is the original weight (g) of the polymer and *b* is the weight (g) of the residue after drying. This insoluble matter was used as an index of solubility.

(2) Rubber elasticity

A polymer sample was pressed by the fingers to qualitatively examine the impact resilience. Clear existance of the impact resilience is expressed as ◎, slight existence as Δ, no existence as X.

(3) Transparency

A sheet 0.5 mm thick was produced. The transparency of this sheet was evaluated by its transmittance (%) measured by an infrared spectrometer when infrared light of 370 mu was applied to the sheet.

(4) Water resistance

A polymer sample was deaerated and formed into a sheet of 2 mm thickness. The sheet was punched to obtain a square sample of 20 mm × 20 mm. The square sample thus obtained was immersed in water at 50°C for 24 hours. The volume expansion ΔV (%) after immersion was used as an index of water resistance.

(5) Processability

A polymer was wound around a hot roll at 80 to 120°C. If the polymer had a poor windability or was very sticky and difficult to process, the polymer was rated as X. Also, when the unwound sheet showed a large shrinkage, the polymer was rated as X. Polymers which had no problems in respect of windability, stickiness and shrinkage were rated as O.

Polymers having a low molecular weight and unable to hold a solid form and accordingly difficult to handle were also rated as X.

As can be appreciated from Table 1, the copolymer of this invention easily dissolves in aqueous alkali solutions and has excellent rubber elasticity, transparency, water resistance and processability. Further, the copolymer can be produced easily and in a high yield by the process of this invention.

Example 4

(Production and application of photosensitive composition)

In a 500 ml, three-necked, separable flask were placed (a) 159.2 g of a 62.8% by weight methanolic solution of a copolymer of butadiene (38 mole %), ethyl acrylate (45 mole %), methacrylic acid (12 mole %), ethylene glycol dimethacrylate (0.8 mole %), and dihydrodicyclopentandienyl acrylate (4.2 mole %), (b) 40.0 g of nonaethylene glycol dimethacrylate (as a photopolymerizable unsaturated monomer), (c) 2.0 g of benzoin isopropyl ether (as a photosensitizer) and (d) 0.1 g of hydroquinone (as a storage stabilizer). The mixture was thoroughly stirred until it formed a solution.

The separable flask containing the solution was immersed in a water bath controlled at about 40°C. The solvent, methanol, was removed from the solution with stirring under reduced pressure to obtain a viscous photosensitive composition.

5.0 g of the resulting photosensitive composition were placed on a styrene-butadiene rubber sheet of area 64 $cm^2$ and thickness 1.0 mm, and a photosensitive composition layer 1.0 mm thick was formed using an applicator having a gap of 1.0 mm.

A negative film having an optical density of 3.5 was placed above the upper surface of the composition

layer while keeping the distance between the film and the composition layer 0.3 mm. Then, the composition layer was exposed to ultraviolet light emitted from a 250 W ultra-high pressure mercury lamp installed at a location 60 cm above the composition layer for 60 seconds through the negative film. On the photosensitive composition after the light exposure was sprayed a 0.5% by weight aqueous sodium hydroxide solution for 2 minutes to effect development, whereby all the unexposed portions of the photoset composition layer were completely dissolved and removed to obtain a resin relief printing plate with a good fidelity to the original image. The resin plate had rubber elasticity, and the rubber hardness (Shore A hardness at 20°C) was 60. Separately, the above produced photosensitive composition layer was exposed to the same ultraviolet light as above for 60 seconds directly without using the negative film. The photoset composition layer was punched to obtain a disk of diameter 3.5 cm. The disk was immersed in a 0.1% aqueous sodium carbonate solution controlled at 40°C for 24 hours. The disk was taken out and its swelling was measured, to find it 1.5%.

The resin relief plate produced as described above was subjected to printing with black letterpress ink, to obtain printed matter with a good ink transferability.

Examples 5 to 10 and Comparative Examples 11 and 12

In a 500 ml, three-necked, separable flask were placed: (a) 159.2 g of a 62.8% by weight methanolic solution of a copolymer (the physical properties are shown in Table 2) of butadiene (38 mole %), ethyl acrylate (49.2 mole %), methacrylic acid (12 mole %), and ethylene glycol dimethacrylate (0.8 mole %); (b) 40.0 g of nonaethylene glycol dimethacrylate (as a photopolymerizable unsaturated monomer); (c) 2.0 g of benzoin isopropyl ether (as a photosensitizer); and (d) 0.1 g of hydroquinone (as a storage stabilizer). The mixture was thoroughly stirred until it became a solution. Then, the separable flask containing the solution was immersed in a water bath controlled at about 40°C, and the solvent, methanol, was removed from the solution while stirring the solution under reduced pressure, to produce a viscous photosensitive composition.

5.0 g of the photosensitive composition were placed on a styrene-butadiene rubber sheet of area 64 $cm^2$ and thickness 1.0 mm and a photosensitive composition layer 1.0 mm thick was formed by using an applicator having a thickness of 1.0 mm. The photosensitive composition layer kept its solid form and was not difficult to handle.

A negative film having an optical density of 3.5 was placed above the composition layer so that the distance between the film and the composition layer became 0.3 mm. Then, the composition layer was exposed to ultraviolet light emitted from a 250 W ultra-high pressure mercury lamp installed at a location 60 cm above the composition layer for 60 seconds through the film. On the photosensitive composition after the light exposure was sprayed a 0.5% by weight aqueous sodium hydroxide solution for 2 minutes to effect development, whereby all the unexposed portions of the photoset composition layer were completely dissolved and removed, thereby producing a resin relief printing plate with a good fidelity to the original image. The resin plate had rubber elasticity and the rubber hardness (Shore A hardness at 20°C) was 60. Separately, the above produced photosensitive composition layer was exposed to the same ultraviolet light as above for 60 seconds directly without using the negative film. The photoset composition layer was punched to obtain a disk of 3.5 cm diameter. The disk was immersed in a 0.1% by weight aqueous sodium carbonate solution controlled at 40°C for 24 hours. The disk was taken out and the degree of swelling was measured to find it 1.5%. The resin relief printing plate was subjected to printing with black letterpress ink, thereby obtaining printed matter with a good ink transferability (Example 5).

In a similar manner, there were produced and evaluated other photosensitive compositions (Examples 6 to 10 and Comparative Examples 11 and 12). The results are shown in Table 2.

The physical properties, such as solubility in aqueous alkali solutions, transparency, processability and the like, of the copolymers used in the photosensitive compositions of Examples 5 to 10 and Comparative Examples 11 and 12 were evaluated according to the same test methods as in Examples 1 to 3 and Comparative Examples 1 to 10.

As can be appreciated from Table 2, the use of the copolymers (I) of Examples 5 to 10 according to this invention enables photosensitive compositions having excellent transparency and processability to be produced.

In contrast, the copolymer of Comparative Example 11 containing no polyfunctional alkenyl compound has poor processability and the copolymer of Comparative Example 12 containing a polyfunctional alkenyl compound in too large an amount has poor solubility in aqueous alkali solutions and accordingly poor alkali developability.

The photosensitive composition of this invention have various advantageous properties such as water resistance, solvent resistance, rubber elasticity, alkali developability, transparency, processability, mechanical characteristics and the like. Hence, they not only provide a resin relief plate for flexographic printing, but can also be widely used as a photosensitive material.

Table 1

| | Example | | | Comparative Example | | | |
|---|---|---|---|---|---|---|---|
| | 1 | 2 | 3 | 1 | 2 | 3 | 4 |
| Polymer composition (mole %) | | | | | | | |
| Butadiene | 36.2 | - | 40 | 5 | - | 30 | 30 |
| Isoprene | - | 25 | - | - | - | - | - |
| Ethylene glycol dimethacrylate | 0.8 | 1 | - | 1 | - | 1 | 1 |
| Divinylbenzene | - | - | 3 | - | 9 | - | - |
| Dicyclopentenyl acrylate | 2 | - | 3 | 2 | 5 | 2 | 2 |
| Ethylidenenorbornene | - | 4 | - | - | - | - | - |
| Acrylic acid | - | 25 | - | - | - | - | - |
| Methacrylic acid | 17 | - | 20 | 20 | 45 | 4 | 55 |
| Ethyl acrylate | 44 | 20 | 34 | 52 | 41 | 50 | - |
| Butyl acrylate | - | 25 | - | 20 | - | 13 | 12 |
| Polymer viscosity, [η] (as measured as 30°C in dimethylformamide) (dl/g) | 0.31 | 0.35 | 0.43 | 0.29 | 0.30 | 0.59 | 0.41 |
| Test results | | | | | | | |
| (1) Solubility in aqueous Alkali solution (insoluble matter %) | 5 | 4 | 10 | 3 | 2 | 58 | 1 |
| (2) Rubber elesticity | ◎ | ◎ | ◎ | Δ | x | ◎ | Δ |
| (3) Transparency (%) | 65 | 61 | 58 | 68 | 70 | 65 | 63 |
| (4) Water resistance (swelling, %) | 2 | 5 | 1 | 4 | 6 | 1 | 10 |
| (5) Processability | O | O | O | O | O | O | O |

Table 1 (Cont'd)

| | Comparative Example | | | | | |
|---|---|---|---|---|---|---|
| | 5 | 6 | 7 | 8 | 9 | 10 |
| Polymer composition (mole %) | | | | | | |
| Butadiene | 30 | 30 | 30 | 30 | 30 | 65 |
| Isoprene | - | - | - | - | - | - |
| Ethylene glycol dimethacrylate | 0.05 | 25 | 1 | 1 | 1 | 1 |
| Divinylbenzene | - | - | - | - | - | - |
| Dicyclopentenyl acrylate | 2.05 | 2 | 15 | 2 | 2 | 2 |
| Ethylidenenorbornene | - | - | - | - | - | - |
| Acrylic acid | - | - | - | - | - | - |
| Methacrylic acid | 20.9 | 20 | 20 | 20 | 20 | 20 |
| Ethyl acrylate | 47 | 23 | 34 | 20 | 20 | 13 |
| Butyl acrylate | - | - | - | 27 | 27 | - |
| Polymer viscosity, [η] (as measured at 30°C in dimethylformamide) (dl/g) | 0.38 | 0.45 | 0.39 | 3.1 | 0.005 | 0.35 |
| Test results | | | | | | |
| (1) Solubility in aqueous alkali solution (insoluble matter %) | 1 | 70 | 43 | 10 | 0 | 15 |
| (2) Rubber elesticity | ◎ | Δ | ◎ | ◎ | ◎ | ◎ |
| (3) Transparency (%) | 8 | 70 | 62 | 52 | 55 | 45 |
| (4) Water resistance (swelling, %) | 6 | 1 | 2 | 1 | 8 | 1 |
| (5) Processability | X | O | O | X | X | X |

Table 2

| | Example | | | | | | Comparative Example | |
|---|---|---|---|---|---|---|---|---|
| | 5 | 6 | 7 | 8 | 9 | 10 | 11 | 12 |
| Copolymer composition (mole %) | | | | | | | | |
| Butadiene | 38 | 38 | 30 | 15 | 38 | 38 | 38 | 38 |
| Methacrylic acid | 12 | 12 | 30 | 8 | 12 | 12 | 12 | 12 |
| Divinylbenzene | - | 15 | - | - | - | - | - | - |
| Ethylene glycol dimethacrylate | 0.8 | - | 0.2 | 1 | 0.8 | 0.8 | - | 25 |
| Ethylidenenorbornene | - | - | - | - | 10 | - | - | - |
| Dicyclopentadiene | - | - | - | - | - | 10 | - | - |
| Ethyl acrylate | 49.2 | 35 | - | 76 | 39.2 | 39.2 | 50 | 25 |
| Butyl acrylate | - | - | 39.8 | - | - | - | - | - |
| Test results | | | | | | | | |
| (1) Solubility in aqueous alkali solution (insoluble, %) | 5 | 10 | 2 | 6 | 5 | 4 | 1 | 61 |
| (2) Rubber elasticity | ◎ | ◎ | ○ | ○ | ◎ | ◎ | ◎ | ○ |
| (3) Transparency (%) | 66 | 70 | 58 | 67 | 65 | 68 | 10 | 69 |
| (4) Water resistance (swelling, %) | 5 | 4 | 6 | 2 | 2 | 2 | 4 | 3 |
| (5) Processability | ○ | ○ | ○ | ○ | ○ | ○ | x | ○ |

**Claims**

1. A photosensitive composition comprising (I) a conjugated diene copolymer comprising: (A) from 10 to 60 mole % of units derived from a conjugated diene compound: (B) from 5 to 50 mole % of units derived from an α,β-ethylenically unsaturated carboxylic acid; (C) from 0.1 to 20 mole % of units derived from a polyfunctional alkenyl compound whose carbon-carbon double bonds are non-conjugated; (D) from 0 to 10 mole % of units derived from a diene compound having at least one carbon-carbon double bond in a carbocyclic system; and (E) from 0 to 80 mole % of units derived from a monoolefinically unsaturated compound, the sum of the amounts of (A), (B), (C), (D) and (E) being 100 mole %, said copolymer having an intrinsic viscosity of from 0.01 to 3.0 dl/g as measured at 30°C in dimethylformamide, (II) a photopolymerisable unsaturated monomer and (III) a photosensitizer.

2. A composition according to Claim 1, wherein the conjugated diene compound (A) is 1,3-butadiene, isoprene, chloroprene or 1,3-pentadiene.

3. A composition according to Claim 1 or claim 2, wherein the α,β-ethylenically unsaturated carboxylic acid (B) unit in the copolymer is acrylic acid, methacrylic acid, maleic acid, fumaric acid, monoethyl maleate or itaconic acid.

4. A composition according to any one preceding claim, wherein the polyfunctional alkenyl compound (C) in the copolymer is a polyacrylate compound, a polymethacrylate compound, divinylbenzene or trivinylbenzene.

5. A composition according to any one preceding claim, wherein the diene compound (D) in the copolymer is dicyclopentenyl acrylate, dicyclopentenyl methacrylate, dicyclopentenyloxyethyl acrylate, dicyclopentandiene, ethylidenenorbornene or vinylnorbornene.

6. A composition according to any one preceding claim, wherein the monoolefinically unsaturated compound (E) in the copolymer is at least one member selected from esters of acrylic and methacrylic acids, styrene, acrylonitrile and vinyl chloride.

7. A composition according to any one preceding claim proportion of the photopolymerizable unsaturated monomer (II) is from 5 to 200 parts by weight per 100 parts by weight of the copolymer (I).

8. A composition according to any one preceding claim wherein the photopolymerizable unsaturated monomer (II) is an unsaturated aromatic compound, an unsaturated nitrile compound, an alkyl acrylate or methacrylate, a hydroxyalkyl acrylate or methacrylate, an alkoxyalkylene glycol acrylate or methacrylate, an α,β-ethylenically unsaturated carboxylic acid or anhydride thereof, a monoester of an unsaturated polycarboxylic acid, a diester, an acrylamide, a methacrylamide, ethylene glycol diacrylate or dimethacrylate, a polyalkylene glycol diacrylate or dimethacrylate, or a polyalcohol diacrylate, triacrylate, tetraacrylate, dimethacrylate, trimethacrylate, tetramethacrylate or oligoacrylate.

9. A composition according to any one preceding Claim wherein the proportion of the photosensitizer (III) is from 0.1 to 10 parts by weight per 100 parts by weight of the copolymer (I).

10. A composition according to any one preceding claim wherein the photosensitizer (III) is a diketone compound, an acyloin compound, an acyloin ether or a polynuclear quinone.

**Patentansprüche**

1. Lichtempfindliche Zusammensetzung, die enthält:
(I) Ein Copolymer auf der Basis eines konjugierten Diens, das enthält:
(A) 10—60 mol-% von einem konjugierten Dien abgeleitete Einheiten;
(B) 5—50 mol-% von einer ethylenisch α.β-ungesättigten Carbonsäure abgeleitete Einheiten;
(C) 0,1 bis 20 mol-% von einer polyfunktionellen Alkenylverbindung, deren C=C-Doppelbindungen nicht konjugiert sind, abgeleitete Einheiten;
(D) 0 bis 10 Mol-% von einer Dienverbindung mit mindestens einer C=C-Doppelbindung in einem carbozyklischen System abgeleitete Einhieten, und
(E) 0 bis 80 mol-% von einer monoolefinisch ungesättigten Verbindung abgeleitete Einheiten, wobei die Summe der Mengen von (A), (B), (C), (D) und (E) 100 mol-% beträgt und das Co-polymer eine Grenzviskositätzahl von 0,01 bis 3,0 dl/g, gemessen bei 30°C in Dimethylformamid, aufweist,
(II) ein photopolymerisierbares ungesättigtes Monomer und
(III) einen Photosensibilisator.

2. Zusammensetzung nach Anspruch 1, dadurch gekennzeichnet, daß das konjugierte Dien (A) 1,3-Butadien, Isopren, Chloropren oder 1,3-Pentadien ist.

3. Zusammensetzung nach Anspruch 1 oder 2, dadurch gekennzeichnet, daß die Einheiten (B) der ethylenisch α,β-ungesättigten Carbonsäure im Copolymer Einheiten von Acrylsäure, Methacrylsäure, Maleinsäure, Fumarsäure, Monoethylmaleat oder Itaconsäure sind.

4. Zusammensetzung nach einem der Ansprüche 1 bis 3, dadurch gekennzeichnet, daß die polyfunktionelle Alkenylverbindung (C) im Copolymer eine Polyacrylatverbindung, eine Polymethacrylatverbindung, Divinylbenzol oder Trivinylbenzol ist.

5. Zusammensetzung nach einem der Ansprüche 1 bis 4, dadurch gekennzeichnet, daß die Dienverbindung (D) im Copolymer Dicyclopentenylacrylat, Dicyclopentenylmethacrylat, Dicyclopentenyloxyethylacrylat, Dicyclopentadien, Ethylidennorbornen oder Vinylnorbornen ist.

6. Zusammensetzung nach einem der Ansprüche 1 bis 5, dadurch gekennzeichnet, daß die monoolefinisch ungesättigte Verbindung (E) im Copolymer mindestens eine unter Acrylsäureestern, Methacrylsäureestern, Styrol, Acrylnitril und Vinylchlorid ausgewählte Verbindung ist.

7. Zusammensetzung nach einem der Ansprüche 1 bis 6, dadurch gekennzeichnet, daß der Mengenanteil des photopolymerisierbaren ungesättigten Monomers (II) 5 bis 200 Masse-Teile auf 100 Masse-Teile des Copolymers (I) beträgt.

8. Zusammensetzung nach einem der Ansprüche 1 bis 7, dadurch gekennzeichnet, daß das photopolymerisierbare ungesättigte Monomer (II) eine ungesättigte aromatische Verbindung, eine ungesättigte Nitrilverbindung, ein Alkylacrylat oder Alkylmethacrylat, eine Hydroxyalkylacrylat oder Hydroxyalkylmethacrylat, ein Alkoxyalkylenglycolacrylat oder Alkoxyalkylenmethacrylat, eine ethylenisch α,β-ungesättigte Carbonsäure oder ein Anhydrid davon, eine Monoester einer ungesättigten Polycarbonsäure, ein Diester, ein Acrylamid, ein Methacrylamid, Ethylenglycoldiacrylat oder Ethylenglycoldimethacrylat, ein Polyalkylenglycoldiacrylat oder Polyalkylenglycoldimethacrylat oder ein Diacrylat, Triacrylat, Tetraacrylat, Dimethacrylat, Trimethacrylat, Tetramethacrylat oder Oligoacrylat eines mehrwertigen Alkohols ist.

9. Zusammensetzung nach einem der Ansprüche 1 bis 8, dadurch gekennzeichnet, daß der Mengenanteil des Photosensibilisators (III) 0,1 bis 10 Masse-Teile auf 100 Masse-Teile des Copolymers (I) beträgt.

10. Zusammensetzung nach einem der Ansprüche 1 bis 9, dadurch gekennzeichnet, daß der Photosensibilisator (III) eine Diketonverbindung, eine Acyloinverbindung, ein Acyloinether oder ein mehrkerniges Chinon ist.

**Revendications**

1. Composition photosensible comprenant (I) un polymère diénique conjugué comprenant: (A) de 10 à 60% en moles d'unités dérivées d'un composé diénique conjugué; (B) de 5 à 50% en moles d'unités dérivées d'un acide carboxylique à insaturation α,β-éthylénique; (C) de 0,1 à 20% en moles d'unités dérivées d'un composé alcénylique polyfunctionnel dont les doubles liaisons carbone-carbone ne sont pas conjugées; (D) de 0 à 10% en moles d'unités dérivées d'un composé diénique ayant au moins une double liaison carbonecarbone dans un système carboxylique; et (E) de 0 à 80% en moles d'unités dérivées d'un composé à insaturation monooléfinique, la somme des quantités (A), (B), (C), (D) et (E) étant de 100% en moles, ledit copolymère ayant une viscosité intrinsèque de 0,01 à 3,0 dl/g mesurée à 30°C dans le diméthylformamide, (II) un monomère insaturé photopolymérisable et (III) un photosensibilisateur.

2. Composition selon la revendication 1, dans laquelle le composé diénique conjugué (A) est le 1,3-butadiène, l'isoprène, le chloroprène ou le 1,3-pentadiène.

3. Composition selon la revendication 1 ou 2, dans laquelle l'unité d'acide carboxylique à insaturation α,β-éthylènique (B) dans le copolymère est l'acide acrylique, l'acide méthacrylique, l'acide maléique, l'acide fumarique, le maléate de monoéthyle ou l'acide itaconique.

4. Composition selon l'une quelconque des revendications précédentes, dans laquelle le composé alcénylique polyfonctionnel (C) dans le copolymère est une composé de type polyacrylate, un composé de type polyméthacrylate, le divinylbenzène ou le trivinylbenzène.

5. Composition selon l'une quelconque des revendications précédentes, dans laquelle le composé diénique (D) dans le copolymère est l'acrylate de dicyclopentényle, le méthacrylate de dicyclopentényle, l'acrylate de dicyclopenténylоxyéthyl, le dicyclopentadiène, l'éthylidènenorbornène ou le vinylnorbornène.

6. Composition selon l'une quelconque des revendications précédentes, dans laquelle le composé à insaturation monooléfinique (E) dans la copolymère est au moins un corps choisi parmi les esters d'acide acrylique et méthacrylique, le styrène, l'acrylonitrile et le chlorure de vinyle.

7. Composition selon l'une quelconque des revendications précédentes, dans laquelle la proportion du monomère insaturé photopolymérisable (II) est de 5 à 200 parties en poids pour 100 parties en poids du copolymère (I).

8. Composition selon l'une quelconque des revendications précédentes, dans laquelle le monomère insaturé photopolymèrisable (II) est un composé aromatique insaturé, un composé de nitrile insaturé, un acrylate ou méthacrylate d'alkyle, un acrylate ou méthacrylate d'hydroxyalkyle, un acrylate ou méthacrylate d'alcoxyalkylèneglycol, un acide carboxylique à insaturation α,β-éthylénique ou son anhydride, un monoester d'un acide polycarboxylique insaturé, un diester, un acrylamide, un méthacrylamide, le diacrylate ou diméthacrylate d'éthylène glycol, un diacrylate ou diméthacrylate de polyalkylène glycol, ou un diacrylate de polyol, le triacrylate, le tétraacrylate, le diméthacrylate, le triméthacrylate, le tétraméthacrylate ou un oligoacrylate.

9. Composition selon l'une quelconque des revendications précédentes, dans laquelle la proportion du photosensibilisateur (III) est de 0,1 à 10 parties en poids pour cent parties en poids du copolymère (I).

10. Composition selon l'une quelconque des revendications précédentes, dans laquelle le photosensibilisateur (III) est un composé dicétonique, un composé d'acyloïne, un éther d'acyloïne ou une quinone polycyclique.

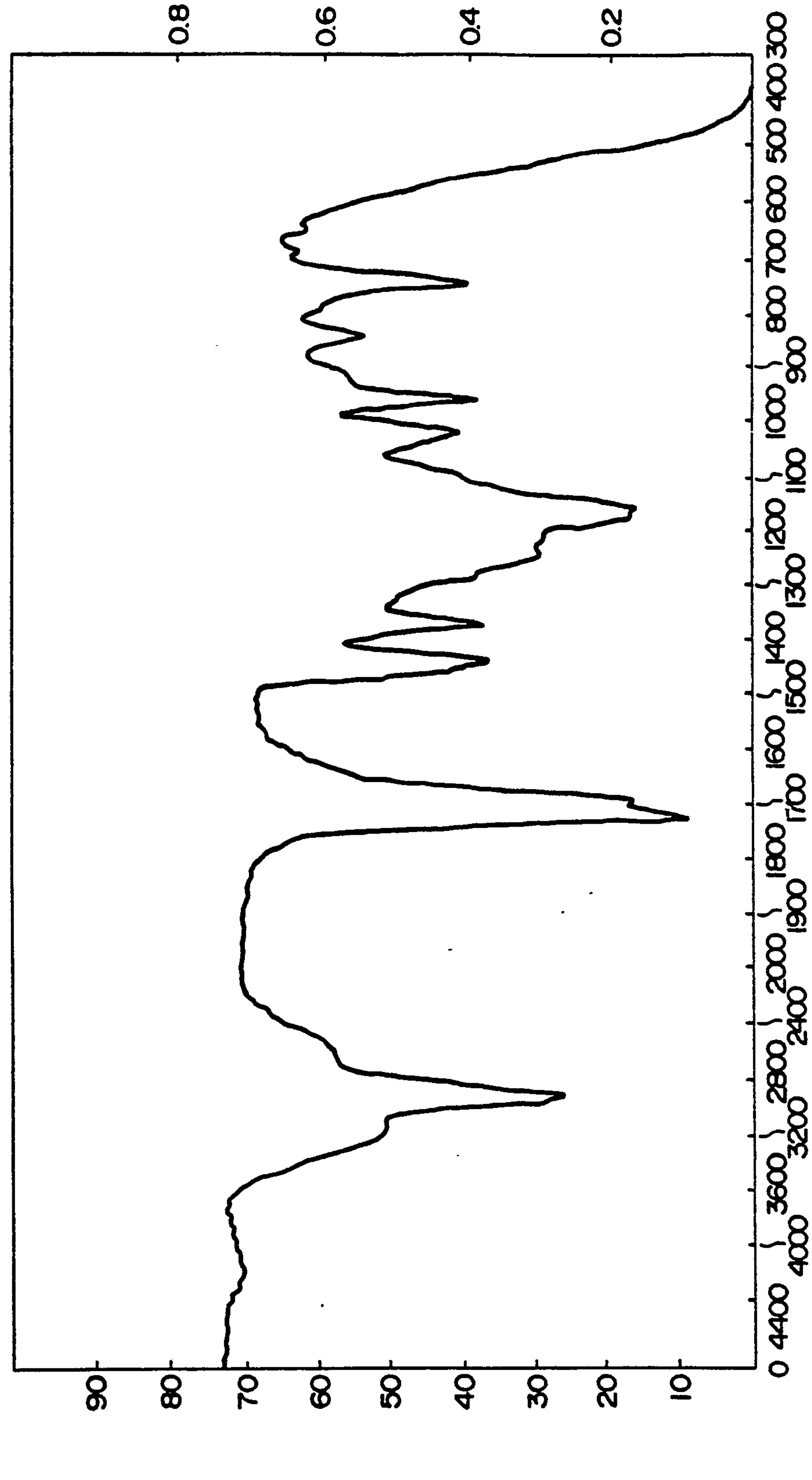
0.8
0.6
0.4
0.2
90
80
70
60
50
40
30
20
10
0
4400
4000
3600
3200
2800
2400
2000
1900
1800
1700
1600
1500
1400
1300
1200
1100
1000
900
800
700
600
500
400
300